# EUROPÄISCHE PATENTANMELDUNG

(11) **EP 4 848 974 A1**
(43) Veröffentlichungstag der Anmeldung: **02.12.2026**
(21) Anmeldenummer: 26179442.4
(22) Anmeldetag: 19.05.2026
(51) Int. Cl.: H10W 72/00, H10W 72/59, H10W 72/90, H10W 40/25

(54) **LEISTUNGSMODUL UND VERFAHREN ZUR HERSTELLUNG EINES LEISTUNGSMODULS**

(30) Priorität: 28.05.2025 DE 102025121169
(71) Anmelder: Volkswagen Aktiengesellschaft, 38440 Wolfsburg (DE)
(72) Erfinder: Otto, Alexander, 38440 Wolfsburg (DE); Hiller, Sebastian, 38440 Wolfsburg (DE); Kraft, Silke, 38440 Wolfsburg (DE); Bayer, Christoph Friedrich, 38440 Wolfsburg (DE)

(57) **Zusammenfassung**

Die Erfindung betrifft ein Leistungsmodul (1), umfassend einen Schaltungsträger (2) und mindestens einen Leistungshalbleiter (7), wobei der Leistungshalbleiter (7) auf einer Unterseite eine Metallisierung (8) aufweist, über die der Leistungshalbleiter (7) mit dem Schaltungsträger (2) elektrisch und thermisch verbunden ist, wobei auf einer Oberseite des Leistungshalbleiters (7) mindestens eine weitere Metallisierung (9) für einen elektrischen Kontakt des Leistungshalbleiters (7) aufgebracht ist, wobei die mindestens eine weitere Metallisierung (9) für den elektrischen Kontakt strukturiert ist, wobei die weitere Metallisierung (9) erste Abschnitte (A1) mit Strukturen (11) mit einer ersten Dicke (D1) aufweist, auf die mindestens ein Bonddraht (10) befestigt ist, und weitere Abschnitte (A2) mit Strukturen (12) mit einer zweiten Dicke (S2) aufweist, wobei die zweite Dicke (D2) kleiner als die erste Dicke (D1) ist, oder zwischen den Strukturen (11) mit der ersten Dicke (D1) Abschnitte (A3) ohne weitere Metallisierung (9) sind, sowie ein Verfahren zur Herstellung eines Leistungsmoduls.

## Beschreibung

Die Erfindung betrifft ein Leistungs-Modul und ein Verfahren zur Herstellung eines LeistungsModuls.

Leistungs-Module weisen typischerweise einen Schaltungsträger auf. Der Schaltungsträger weist beispielsweise eine Keramik auf, die auf einer Unterseite und einer Oberseite jeweils eine Metallisierung aufweist. Dabei ist die Metallisierung auf der Oberseite strukturiert, d.h. auf der Oberseite befinden sich Strukturen, die elektrisch getrennt sind. Die Metallisierung auf der Unterseite dient z.B. zur thermischen Anbindung an einen Kühlkörper. Auf die Strukturen auf der Oberseite werden beispielsweise Leistungshalbleiter angeordnet. Dazu weisen die Leistungshalbleiter an der Unterseite eine Metallisierung auf, die beispielsweise aus mehreren Schichten verschiedener Metalle ausgebildet ist und verschiedene Funktionen erfüllt wie beispielsweise als Diffusionsbarriere oder Kontaktschicht oder Oxidationsschutzschicht dient. An dieser Metallisierung wird der Leistungshalbleiter beispielsweise mittels einer Lot- oder Sinterschicht an den Schaltungsträger angebunden, sodass eine elektrische Kontaktierung zwischen der Unterseite des Leistungshalbleiters und der metallischen Struktur auf der Keramik hergestellt wird. Ist der Leistungshalbleiter ein MOSFET, so ist häufig der Drain-Kontakt an der Unterseite angeordnet, wobei auf der Oberseite mindestens ein Source-Kontakt und mindestens ein Gate-Kontakt angeordnet sind. Der Source-Kontakt und der Gate-Kontakt benötigen ebenfalls eine Metallisierung, damit die Kontakte elektrisch verbunden werden können, wobei die elektrische Verbindung häufig über Bonddrähte erfolgt. Insbesondere der Source-Kontakt weist häufig wegen der Stromtragfähigkeit mehrere Bonddrähte auf. Die Bonddrähte sind beispielsweise aus Aluminium oder Kupfer und weisen einen Durchmesser von beispielsweise 300 µm - 500 µm Durchmesser auf. Ein häufig verwendetes Bondverfahren ist das Ultraschall-Drahtbonden. Dabei besteht insbesondere bei Kupferbonddrähten die Gefahr, dass der Leistungshalbleiter beschädigt wird, sodass die Metallisierung auf der Oberseite ausreichend dick sein muss. Beispielsweise ist die Metallisierung 10 µm - 50 µm dick. Durch die dicke Metallisierung kann es zu einer Verbiegung des Wafer kommen (und damit auch der Leistungshalbleiter auf dem Wafer). Daher wird versucht, die Metallisierung so dünn wie möglich auszubilden, ohne dass der Leistungshalbleiter beim Ultraschall-Drahtbonden beschädigt wird. Dies erweist sich aufgrund der Prozesstoleranzen als schwierig.

Der Erfindung liegt das technische Problem zugrunde, ein Leistungsmodul zu schaffen, bei dem die Verbiegung des Leistungshalbleiters reduziert ist und dennoch der Leistungshalbleiter vor Beschädigung durch das Ultraschall-Drahtbonden geschützt ist. Ein weiteres technisches Problem ist die Bereitstellung eines entsprechenden Verfahrens.

Die Lösung des technischen Problems ergibt sich durch ein Leistungsmodul mit den Merkmalen des Anspruchs 1 sowie ein Verfahren mit den Merkmalen des Anspruchs 10. Weitere vorteilhafte Ausgestaltungen der Erfindung ergeben sich aus den Unteransprüchen.

Das Leistungsmodul weist einen Schaltungsräger und mindestens einen Leistungshalbleiter auf. Der Leistungshalbleiter weist auf einer Unterseite eine Metallisierung auf, über die der Leistungshalbleiter mit dem Träger elektrisch und thermisch verbunden ist. Auf einer Oberseite des Leistungshalbleiters ist mindestens eine weitere Metallisierung für einen elektrischen Kontakt des Leistungshalbleiters angeordnet. Die mindestens eine weitere Metallisierung für den elektrischen Kontakt ist strukturiert, wobei die weitere Metallisierung erste Abschnitte mit Strukturen mit einer ersten Dicke aufweist, auf die mindestens ein Bonddraht befestigt ist. Weiter weist die weitere Metallisierung weitere Abschnitte mit Strukturen mit einer zweiten Dicke auf, wobei die zweite Dicke kleiner als die erste Dicke ist. Alternativ sind zwischen den Strukturen mit der ersten Dicke Abschnitte ohne weitere Metallisierung. Die Grundidee ist dabei, die vollflächige dicke weitere Metallisierung zu strukturieren, sodass einerseits Abschnitte mit ausreichender Dicke für das Bonden existieren und andererseits durch das Strukturieren die Gesamtmenge an weiterer Metallisierung reduziert wird, sodass die Verbiegung reduziert wird.

Dies kann auf verschiedene Weisen realisiert werden.

In einer Ausführungsform sind die weiteren Abschnitte oder die Abschnitte ohne weitere Metallisierung als horizontale und/oder vertikale Gräben zwischen den ersten Abschnitten ausgebildet. Der Vorteil dieser Ausführungsform ist die sehr einfache technische Umsetzung. Die Gräben haben beispielsweise eine Breite von 0,01 µm - 500 µm, weiter vorzugsweise 1 µm - 200 µm.

In einer alternativen Ausführungsform sind die ersten Abschnitte als Pins ausgebildet. Hierdurch kann die Einsparung an weiterer Metallisierung verbessert werden, allerdings ist die technische Umsetzung etwas aufwendiger als bei den Gräben.

In einer alternativen Ausführungsform weisen die ersten Abschnitte eine Wabenstruktur auf, sind also sechseckig ausgebildet. Hierdurch kann die bondbare Fläche optimiert werden.

In einer weiteren alternativen Ausführungsform weist die weitere Metallisierung Einbuchtungen auf. Auch hierdurch wird die Gesamtmenge an weiterer Metallisierung reduziert, wobei Spannungsspitzen wirksamer verhindert werden können.

In einer weiteren Ausführungsform weisen die Strukturen mit einer ersten Dicke unterschiedlich große Flächen auf. Hierdurch kann die Biegung eingestellt werden.

In einer weiteren Ausführungsform ist die weitere Metallisierung aus Kupfer. Dies hat Vorteile, da die Bonddrähte vorzugsweise auch aus Kupfer sind, wobei Kupfer eine gute Wärmeleitfähigkeit und einen geringen Widerstand aufweist. Alternativ ist die weitere Metallisierung geschichtet ausgebildet und weist eine Nickel- und eine darüberliegende Kupferschicht auf. Hierdurch kann insbesondere die Härte der weiteren Metallisierung eingestellt werden.

Dabei sei angemerkt, dass zwischen der Oberseite des Leistungshalbleiters und der weiteren Metallisierung z.B. noch Diffusionsbarrieren und Haftvermittlerschichten angeordnet sein können. Die Diffusionsbarriere ist beispielsweise aus Chrom oder Titan.

In einer weiteren Ausführungsform sind die weiteren Abschnitte oder die Abschnitte zwischen den Strukturen des ersten Abschnitts ohne weitere Metallisierung mit einem festen Medium gefüllt. Das feste Medium kann beispielsweise ein Polymer oder ein weiteres Metall sein. Das Polymer kann beispielsweise ein Transfermold oder ein Photoresist sein.

In einer weiteren Ausführungsform ist der mindestens eine Leistungshalbleiter als SiC-MOSFET ausgebildet.

Weiter vorgeschlagen wird ein Verfahren zur Herstellung eines Leistungsmoduls. Das Leistungsmodul weist einen Schaltungsträger auf, wobei der Schaltungsträger eine Keramik aufweist. Dabei ist auf einer Unterseite der Keramik und auf einer Oberseite der Keramik eine Metallisierung aufgebracht. Die Metallisierung auf der Oberseite wird strukturiert. Weiter wird ein Leistungshalbleiter mittels einer Metallisierung und weiterer Aufbau- und Verbindungstechnik wie beispielsweise einer Lot- oder Sinterschicht an einer Unterseite des Leistungshalbleiters mit einer Struktur auf der Oberseite der Keramik elektrisch verbunden. Auf die Oberseite des Leistungshalbleiters wird mindestens eine weitere Metallisierung für einen elektrischen Kontakt des Leistungshalbleiters aufgebracht, wobei die mindestens eine weitere Metallisierung für den elektrischen Kontakt strukturiert wird, wobei die weitere Metallisierung erste Abschnitte mit Strukturen mit einer ersten Dicke aufweist, auf die mindestens ein Bonddraht befestigt wird, und weitere Abschnitte mit Strukturen mit einer zweiten Dicke aufweist, wobei die zweite Dicke kleiner als die erste Dicke ist, oder zwischen den Strukturen mit der ersten Dicke Abschnitte ohne weitere Metallisierung sind.

Hinsichtlich der weiteren verfahrensmäßigen Ausführungsformen wird auf die vorangegangenen Ausführungen zum Leistungsmodul Bezug genommen.

Die Erfindung wird nachfolgend anhand bevorzugter Ausführungsbeispiele näher erläutert. Die Figuren zeigen:
- Fig. 1: eine schematische Darstellung eines Leistungsmoduls,
- Fig. 2: eine schematische Seitenansicht auf einen Leistungshalbleiter,
- Fig. 3: eine schematische Draufsicht auf einen Leistungshalbleiter,
- Fig. 4: eine schematische Seitenansicht auf einen Leistungshalbleiter in einer weiteren Ausführungsform,
- Fig. 5: eine schematische Seitenansicht auf einen Leistungshalbleiter in einer weiteren Ausführungsform,
- Fig. 6: eine schematische Draufsicht auf einen Leistungshalbleiter in einer weiteren Ausführungsform,
- Fig. 7: eine schematische Seitenansicht eines Leistungshalbleiters in einer weiteren Ausführungsform,
- Fig. 8: eine Darstellung einer Wabenstruktur,
- Fig. 9: eine schematische Seitenansicht einer weiteren Ausführungsform eines Leistungshalbleiters,
- Fig. 10a - 10e: eine schematische Darstellung eines Verfahrensablaufs einer Strukturierung in einer ersten Ausführungsform und
- Fig. 11a - 11e: eine schematische Darstellung eines Verfahrensverlaufs einer Strukturierung in einer zweiten Ausführungsform.

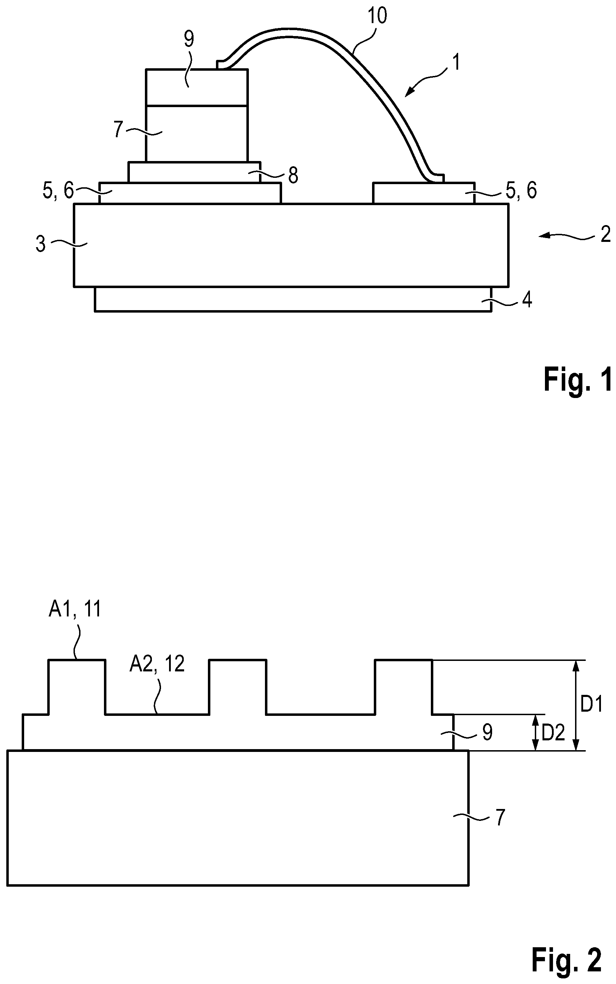

In der Fig. 1 ist schematisch ein Leistungsmodul 1 dargestellt. Das Leistungsmodul 1 weist einen Schaltungsträger 2 auf, der eine Keramik 3 aufweist. Auf einer Unterseite der Keramik 3 ist eine Metallisierung 4 aufgebracht. Auf einer Oberseite der Keramik 3 ist eine weitere Metallisierung 5 aufgebracht, die strukturiert ist und elektrisch voneinander getrennte Strukturen 6 aufweist. Die Metallisierungen 4, 5 können aus Kupfer oder Aluminium sein. Der Schaltungsträger 2 kann z.B. als IMS (Insulated Metal Substrate), DBC (Direct Bonded Copper) oder AMB (Active Metal Brazing) ausgebildet sein.

Auf einer Struktur 6 ist ein Leistungshalbleiter 7 angeordnet, der beispielsweise als SiC-MOSFET ausgebildet ist. An einer Unterseite des Leistungshalbleiters 7 sind eine Metallisierung 8 sowie eine nicht dargestellte Lot- oder Sinterschicht angeordnet, über die eine elektrische Verbindung zur Struktur 6 hergestellt wird. Die Metallisierung 8 ist beispielsweise ein mehrlagiger Metall-Schichtstapel auf dem Leistungshalbleiter. Auf einer Oberseite des Leistungshalbleiters 7 ist eine weitere Metallisierung 9 aufgebracht. Über einen Bonddraht 10 ist die weitere Metallisierung 9 mit einer anderen Struktur 6 elektrisch verbunden. Das Leistungsmodul 1 kann zusätzlich noch Lastanschlüsse aufweisen sowie mit einer Isoliermasse umhüllt sein (z.B. mit einer Vergussmasse vergossen oder von einem Transfer-Mold-Masse umspritzt sein). Um durch den Bondprozess den Leistungshalbleiter 7 nicht zu beschädigen, muss die weitere Metallisierung 9 ausreichend dick sein. Allerdings führen die dicken Schichten zu einer Verbiegung des Wafers bzw. Chips (Leistungshalbleiter 7) bei der Fertigung.

Daher wird die weitere Metallisierung 9 strukturiert, was in Fig. 2 in einer ersten Ausführungsform dargestellt ist. Dazu weist die weitere Metallisierung 9 erste Abschnitte A1 mit Strukturen 11 mit einer ersten Dicke D1 auf. Auf diese ersten Abschnitte A1 wird der mindestens eine Bonddraht 10 befestigt. Weiter weist die weitere Metallisierung 9 weitere Abschnitte A2 mit Strukturen 12 mit einer zweiten Dicke D2 auf, wobei die zweite Dicke D2 kleiner als die erste Dicke D1 ist. Durch diese Strukturierung werden einerseits Abschnitte A1 mit ausreichender Dicke D1 für den Bondprozess zur Verfügung gestellt, wobei die Verbiegung gegenüber einer planaren Metallisierung 9 verbessert ist.

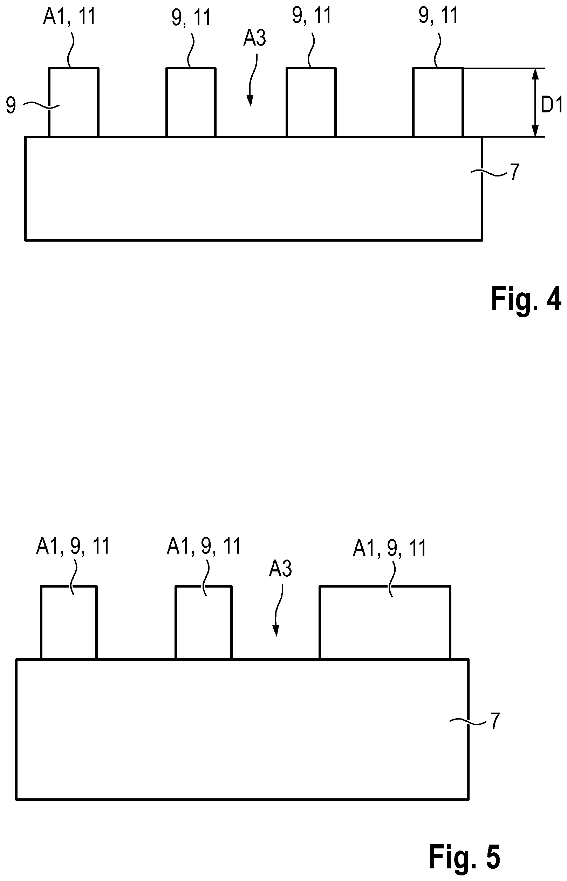

Alternativ sind zwischen den Strukturen 11 des ersten Abschnitts A1 mit der ersten Dicke D1 weitere Abschnitte A3 ohne weitere Metallisierung, was in Fig. 4 dargestellt ist.

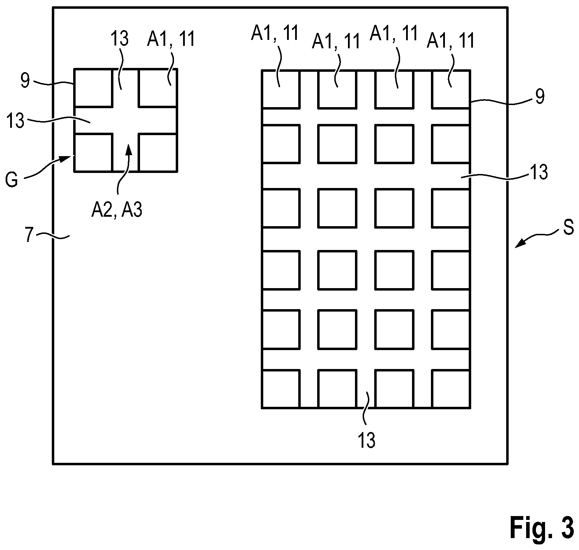

Die weiteren Abschnitte A2 oder die Abschnitte A3 ohne weitere Metallisierung 9 sind als horizontale und/oder vertikale Gräben zwischen den ersten Abschnitten A1 ausgebildet. Dies ist beispielhaft stark schematisch in Fig. 3 dargestellt. Dabei verlaufen die horizontalen Gräben 13 von links nach rechts und die vertikalen Gräben 13 von unten nach oben. Dabei ist ein Source-Kontakt S und ein Gate-Kontakt G dargestellt, die jeweils eine strukturierte Metallisierung 9 aufweisen, wobei aufgrund der kleineren flächenmäßigen Ausdehnung des Gate-Kontakts G das Problem der Biegung geringer ist und daher nicht zwingend die weitere Metallisierung 9 des Gate-Kontakts G strukturiert sein muss. Die Strukturierung mittels der Gräben 13 ist relativ einfach, sodass sich die Strukturierung gut anpassen lässt (Größe der Abschnitte A1, Breite der Gräben 13), um ein gewünschtes Verhalten einzustellen.

In der Fig. 5 ist schematisch dargestellt, dass die Größe der Strukturen 11 des ersten Abschnitts auch unterschiedlich sein kann.

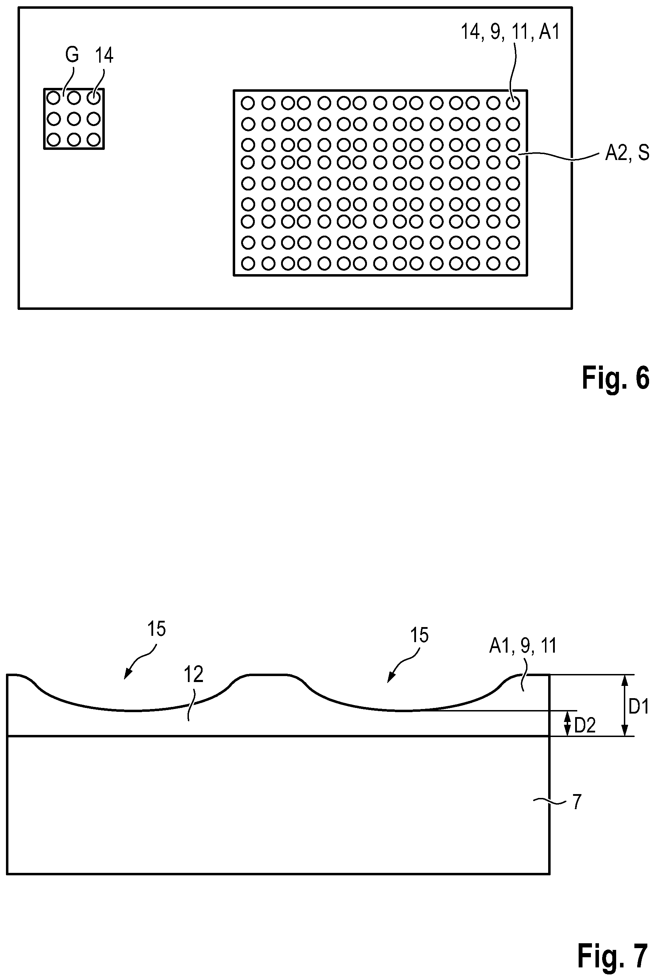

In der Fig. 6 ist stark schematisch in einer Draufsicht eine weitere Ausführungsform dargestellt. Dabei sind die Strukturen 11 als Pins 14 ausgebildet, die rechteckförmig oder zylinderförmig ausgebildet sind.

In der Fig. 7 ist eine weitere alternative Ausführungsform im Querschnitt dargestellt. Dabei weist die weitere Metallisierung 9 Einbuchtungen 15 auf, sodass sich ein kontinuierlicher Übergang von den Strukturen 11 zu den Strukturen 12 am Boden der Einbuchtungen 15 einstellt.

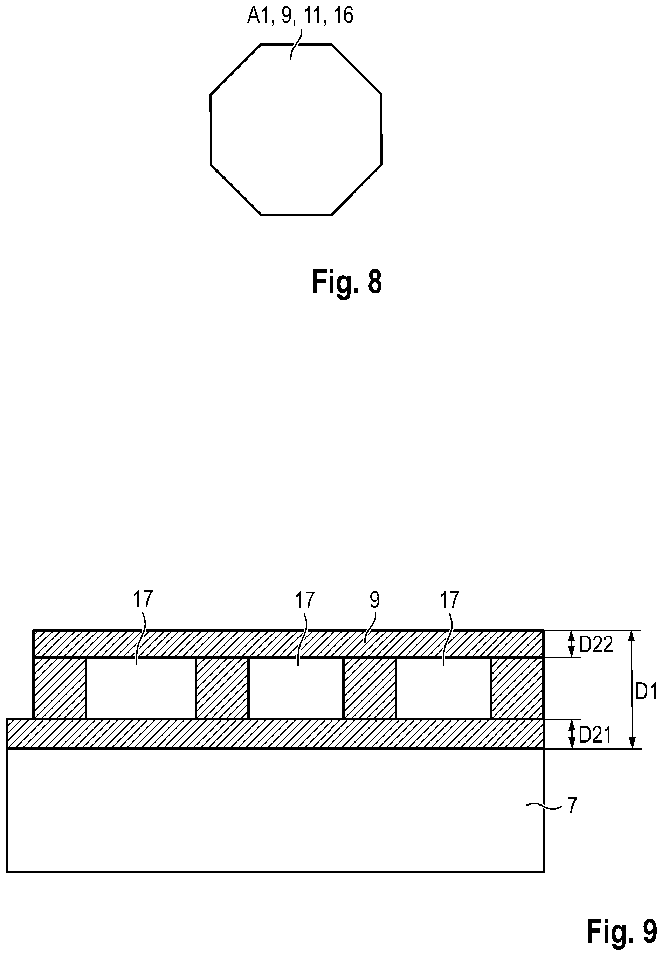

In der Fig. 8 ist eine Struktur 11 der weiteren Metallisierung 9 dargestellt, die eine Wabenstruktur 16 aufweist. Mittels der Wabenstrukturen 16 lässt sich die Fläche für die Bonddrähte 10 optimieren.

Schließlich ist in Fig. 9 eine weitere alternative Ausführungsform für die weitere Metallisierung 9 dargestellt. Anschaulich werden dabei die Strukturen 12 der weiteren Abschnitte A2 durch zwei Teilelemente gebildet, wobei ein erstes Teilelement eine Dicke D21 und ein zweites Teilelement eine Dicke D22 aufweist, wobei die Summe von D21 und D22 die Gesamtdicke D2 bildet. Zwischen den beiden Teilelementen ist beispielsweise ein Polymer, beispielsweise Photoresistlack 17.

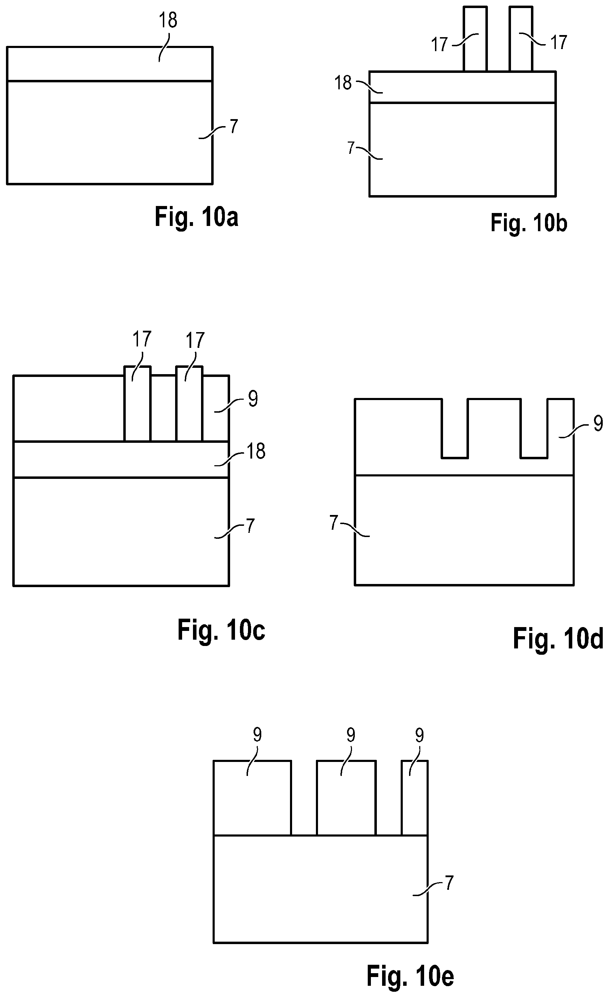

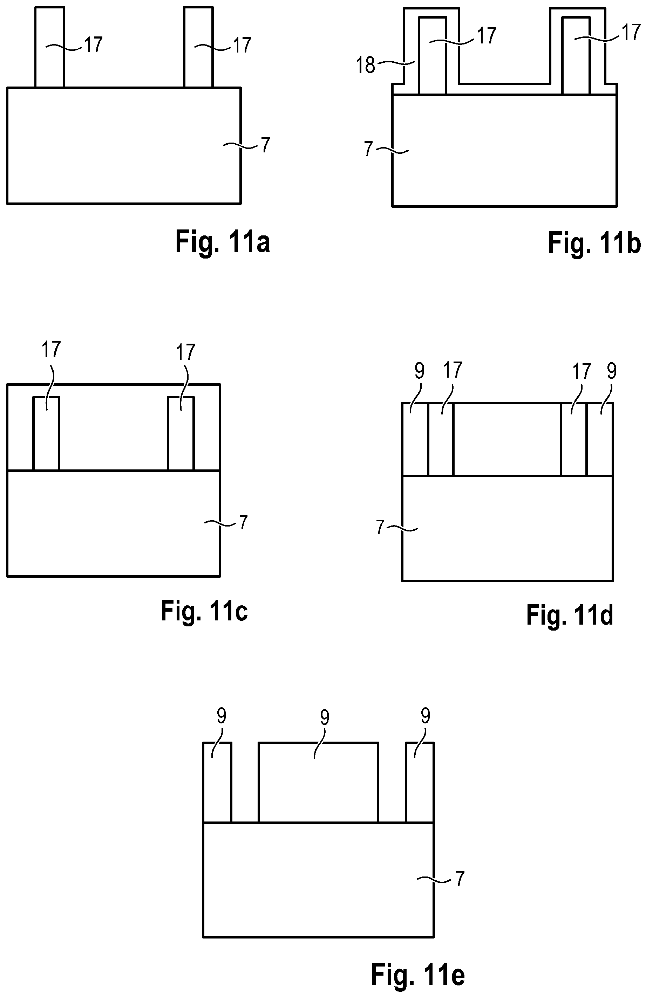

Die Möglichkeiten zur Herstellung der strukturierten Metallisierung 9 des Leistungshalbleiters sollen nun anhand der Fig. 10a - 10e sowie Fig. 11a - 11e näher erläutert werden.

In der Fig. 10a ist ein Leistungshalbleiter 7 dargestellt, auf den eine dünne Schicht 18 eines Metalls, beispielsweise Kupfer oder Nickel, vollflächig aufgebracht wird. Beispielsweise wird die dünne Schicht 18 gesputtert oder aufgedampft. Anschließend wird im Photolithografie-Verfahren ein Photoresistlack 17 auf die dünne Schicht 18 aufgebracht, lokal belichtet und stellenweise wieder entfernt (siehe auch Fig. 10b). Anschließend wird mittels galvanischer oder chemischer Abscheidung die Schichtstärke des Metalls an den nicht vom Photoresistlack abgedeckten Bereichen weiter erhöht. Da der Photoresistlack 17 nicht elektrisch leitfähig ist, wächst dort kein Metall auf (siehe auch Fig. 10c). Anschließend wird der Photoresistlack 17 durch ein Lösungsmittel entfernt (Photoresist-Strip), sodass sich eine Strukturierung gemäß Fig. 10d ergibt. Dies entspricht aber auch der Strukturierung gemäß Fig. 2. Möchte man eine Struktur gemäß Fig. 4 oder Fig. 5, so kann dies durch Ätzen des Metalls erreicht werden (siehe auch Fig. 10e).

Ein alternatives Verfahren ist in Fig. 11a bis Fig. 11e dargestellt, wo zunächst ein Photoresistlack 17 auf den Leistungshalbleiter 7 aufgebracht, lokal belichtet und lokal wieder entfernt wird (siehe auch Fig. 11a). wird Anschließend eine dünne Schicht 18 Metall aufgesputtert oder aufgedampft (siehe auch Fig. 11b). Durch das Sputtern oder Aufdampfen wird auch der Photoresistlack 17 bedeckt. Anschließend wird Metall, beispielsweise Kupfer oder Nickel, galvanisch abgeschieden (siehe auch Fig. 11c) und anschließend durch ein chemischmechanisches Planarisieren/Polieren (CMP) bearbeitet (siehe auch Fig. 11d). Würde man auf diese Struktur weiteres Metall aufsputtern, erhielte man die Ausführungsform gemäß Fig. 9. Entfernt man den Photoresistlack 17 (siehe auch Fig. 11e), so erhält man wieder eine Struktur gemäß Fig. 4 oder Fig. 5.

### Bezugszeichenliste

- 1: Leistungsmodul
- 2: Schaltungsträger
- 3: Keramik
- 4: Metallisierung
- 5: Metallisierung
- 6: Struktur
- 7: Leistungshalbleiter
- 8: Metallisierung
- 9: Metallisierung
- 10: Bonddraht
- 11: Struktur
- 12: Struktur
- 13: Graben
- 14: Pin
- 15: Einbuchtung
- 16: Wabenstruktur
- 17: Photoresistlack
- 18: dünne Schicht
- A1 - A3: Abschnitte
- D1, D2: Dicken
- D21, D22: Dicken
- G: Gate-Kontakt
- S: Source-Kontakt

## Patentansprüche

1. Leistungsmodul (1), umfassend einen Schaltungsträger (2) und mindestens einen Leistungshalbleiter (7), wobei der Leistungshalbleiter (7) auf einer Unterseite eine Metallisierung (8) aufweist, über die der Leistungshalbleiter (7) mit dem Schaltungsträger (2) elektrisch verbunden ist, wobei auf einer Oberseite des Leistungshalbleiters (7) mindestens eine weitere Metallisierung (9) für einen elektrischen Kontakt des Leistungshalbleiters (7) aufgebracht ist,
**dadurch gekennzeichnet, dass**
die mindestens eine weitere Metallisierung (9) für den elektrischen Kontakt strukturiert ist, wobei die weitere Metallisierung (9) erste Abschnitte (A1) mit Strukturen (11) mit einer ersten Dicke (D1) aufweist, auf die mindestens ein Bonddraht (10) befestigt ist, und weitere Abschnitte (A2) mit Strukturen (12) mit einer zweiten Dicke (S2) aufweist, wobei die zweite Dicke (D2) kleiner als die erste Dicke (D1) ist, oder zwischen den Strukturen (11) mit der ersten Dicke (D1) Abschnitte (A3) ohne weitere Metallisierung (9) sind.

2. Leistungsmodul (1) nach Anspruch 1, **dadurch gekennzeichnet, dass** die weiteren Abschnitte (A2) oder die Abschnitte (A3) ohne weitere Metallisierung (9) als horizontale und/oder vertikale Gräben (13) zwischen den ersten Abschnitten (A1) ausgebildet sind.

3. Leistungsmodul (1) nach Anspruch 1, **dadurch gekennzeichnet, dass** die ersten Abschnitte (A1) als Pins (14) ausgebildet sind.

4. Leistungsmodul (1) nach Anspruch 1, **dadurch gekennzeichnet, dass** die ersten Abschnitte (A1) jeweils eine Wabenstruktur (16) aufweisen.

5. Leistungsmodul (1) nach Anspruch 1, **dadurch gekennzeichnet, dass** die weitere Metallisierung (9) Einbuchtungen (15) aufweist.

6. Leistungsmodul (1) nach einem der vorangegangenen Ansprüche, **dadurch gekennzeichnet, dass** die Strukturen (11) mit der ersten Dicke (D1) unterschiedlich große Flächen aufweisen.

7. Leistungsmodul (1) nach einem der vorangegangenen Ansprüche, **dadurch gekennzeichnet, dass** die weitere Metallisierung (9) aus Kupfer ist oder eine Kupfer-Nickel-Schichtung ist.

8. Leistungsmodul (1) nach einem der vorangegangenen Ansprüche, **dadurch gekennzeichnet, dass** die weiteren Abschnitte (A2) oder die Abschnitte (A3) zwischen den Strukturen (11) des ersten Abschnitts (A1) ohne weitere Metallisierung (9) mit einem festen Medium gefüllt sind.

9. Leistungsmodul (1) nach einem der vorangegangenen Ansprüche, **dadurch gekennzeichnet, dass** der mindestens eine Leistungshalbleiter (7) als SiC-MOSFET ausgebildet ist.

10. Verfahren zur Herstellung eines Leistungsmoduls (1), wobei das Leistungsmodul (1) einen Schaltungsträger (2) aufweist, wobei der Schaltungsträger (2) eine Keramik (3) aufweist, wobei auf einer Unterseite der Keramik (3) und auf einer Oberseite der Keramik (3) eine Metallisierung (4, 5) aufgebracht ist, wobei die Metallisierung (5) auf der Oberseite strukturiert ist, wobei ein Leistungshalbleiter (7) mittels einer Metallisierung (8) an einer Unterseite des Leistungshalbleiters (7) mit einer Struktur (6) auf der Oberseite der Keramik (3) elektrisch verbunden wird, wobei auf die Oberseite des Leistungsmoduls (1) mindestens eine weitere Metallisierung (9) für einen elektrischen Kontakt des Leistungshalbleiters (7) aufgebracht wird, wobei die mindesten eine weitere Metallisierung (9) für den elektrischen Kontakt strukturiert wird, wobei die weitere Metallisierung (9) erste Abschnitte (A1) mit Strukturen (11) mit einer ersten Dicke (D1) aufweist, auf die mindestens ein Bonddraht (10) befestigt wird, und weitere Abschnitte (A2) mit Strukturen (12) mit einer zweiten Dicke (D2) aufweist, wobei die zweite Dicke (D2) kleiner als die erste Dicke (D1) ist, oder zwischen den Strukturen (11) mit der ersten Dicke (D1) Abschnitte (A3) ohne weitere Metallisierung (9) sind.
